# EUROPEAN PATENT APPLICATION

(11) **EP 0 683 523 A2**
(43) Date of publication of application: **22.11.1995**
(21) Application number: 95303041.8
(22) Date of filing: 03.05.1995
(51) Int. Cl.: H01L 27/112

(54) **Metal programmed transistor array**

(30) Priority: 05.05.1994 US 238534
(71) Applicant: ADVANCED MICRO DEVICES INC., Sunnyvale, California 94088-3453 (US)
(72) Inventor: Allee, Daren L., Austin, Texas 78748 (US)
(74) Representative: Sanders, Peter Colin Christopher

(57) **Abstract**

A silicon semi-conductor comprising a substrate with a plurality of columns of implants therein and an oxide layer thereover is disclosed. Within the oxide layer are a plurality of rows of polycrystalline material. The columns of implants and rows of polycrystalline silicon material are arranged to form an array of transistors with the implants connected in series in a plurality of columns, and with each row of polycrystalline material acting as the gate for the transistors in a specific row of the array. Contact windows are etched through the oxide layer to each implant. A plurality of metal layer paths are formed on the oxide layer which also pass through the contact windows and make electrical connection with the implants therebelow. The metal layer also has various paths which define jumpers electrically short out various transistors in the array, as necessary to meet specific programming requirements of a customer.

## Description

This application is related to the following European Applications:

| **Application No.** | **Filing Date** | **Our Reference** |
|---|---|---|
| 93305465.2 | 13.07.93 | TT0139/HRW |
| 93305458.7 | 13.07.93 | TT0140/HRW |
| 93305450.4 | 13.07.93 | TT0141/PCCS |
| 93305457.9 | 13.07.93 | TT0142/PCCS |
| 93305466.0 | 13.07.93 | TT0143/HRW |
| 93305459.5 | 13.07.93 | TT0144/PCCS |
| 93305482.7 | 13.07.93 | TT0145/PCCS |
| 93305454.6 | 13.07.93 | TT0146/HRW |
| 93305461.1 | 13.07.93 | TT0147/HRW |
| 93305456.1 | 13.07.93 | TT0148/HRW |
| 93305449.6 | 13.07.93 | TT0149/HRW |
| 93305453.8 | 13.07.93 | TT0150/HRW |
| 95300695.4 | 03.02.95 | TT0410/PCCS |
| 95300694.7 | 03.02.95 | TT0411/PCCS |
| 95300696.2 | 03.02.95 | TT0412/PCCS |
| 95300697.0 | 03.02.95 | TT0413/PCCS |
| 95300698.8 | 03.02.95 | TT0414/PCCS |
| 95300689.7 | 03.02.95 | TT0415/PCCS |
| 95300691.3 | 03.02.95 | TT0416/PCCS |
| 95300690.5 | 03.02.95 | TT0417/PCCS |
| 95300692.1 | 03.02.95 | TT0418/PCCS |

All of the related applications are in the name of the present Applicant and are hereby incorporated herein in their entirety by this reference thereto.

### MASK WORK NOTICE

A portion of the disclosure of this patent document may contain material which is subject to mask work protection. The mask work owner has no objection to the facsimile reproduction by anyone of the patent document or the patent disclosure, as it appears in the Patent and Trademark Office patent file or records, but otherwise reserves all mask work rights whatsoever.

The invention relates to semi-conductor devices, and more particularly, to semi-conductor devices having an array of transistors connected in a predetermined arrangement.

Silicon semi-conductor devices are manufactured through a series of steps carried out in a particular order. The way in which those steps are carried out is crucial to the result achieved from the manufacturing process. The main objective in manufacturing those devices is to obtain a device which conforms to geographical and topographical features of a particular, desired design for the device. In order to obtain this objective, steps in the manufacturing process must be closely controlled to ensure that rigid requirements, for example, of exacting tolerances, quality materials, and clean environment, are met.

A wide variety of processing techniques may be employed in manufacturing silicon semi-conductor devices. In most of those devices, silicon is employed as a semi-conductor for conducting of electricity. The device manufacturing process typically begins with a silicon wafer workpiece. The silicon wafer workpiece is formed of a single-crystal silicon (Si). Single-crystal silicon is required because optimization of the final product device depends upon the conformance of the device through each fabrication step to particular geographic/topographic requirements. This can be better understood by further consideration of typical steps in the manufacturing process of an integrated circuit formed of a silicon semi-conductor device.

Beginning with a silicon wafer workpiece, as previously described, a desired pattern is transferred to the surface of the wafer. This pattern may be formed on the wafer surface in a variety of manners. For example, in many instances, a layer of silicon dioxide (SiO₂, sometimes also referred to herein as "oxide") is grown upon the surface of the wafer. Silicon dioxide serves as an insulative material and so is often used to separate various semi-conducting layers of integrated circuits formed of silicon semi-conductor devices. A variety of methods may be employed to force oxide growth on the wafer, including, for example, thermal oxidation. In thermal oxidation, silicon on the wafer reacts with oxygen to form a continuous layer of high-quality silicon dioxide. A film of silicon dioxide could also be formed on the surface of a wafer in other manners.

The silicon dioxide is formed on the wafer's surface in uniform layers or in particular patterns, as desired. A variety of techniques, including, for example, photolithography, may be employed to achieve desired wafer surface configurations. In photolithography, a photo resist material, for example, a photo-sensitive polymer, may be layered atop a somewhat uniform silicon dioxide layer on a wafer surface. A mask having a desired design of clear and opaque areas may then be positioned atop the photo resist layer. Photo resist will selectively respond to UV light, for example, by molecular degradation in areas exposed to such light. As a result of this selective response characteristic of photo resist, the photo resist can be selectively subjected to UV light; for example, because of respective clear and opaque areas of a mask, to form particular patterns of photo resist material atop the silicon dioxide.

Once a particular pattern of photoresist is formed atop the silicon dioxide of the wafer, portions of the wafer topped by silicon dioxide but not topped by photoresist may then be etched away from the wafer surface. Etching is a common procedure employed in manufacture of integrated circuits formed of silicon semi-conductor devices. In general terms, etching is a process by which portions of a workpiece may be selectively removed from the workpiece. The etch process yields a workpiece having a desired geographical/topographical arrangement, for further processing. After the etch, the photoresist is removed by a subsequent processing step, leaving the silicon wafer topped only by select configurations of silicon dioxide. As will be hereinafter more fully described, a variety of etching techniques may be employed.

In addition to the silicon dioxide/photoresist/etch method previously described, there are various other methods for selectively forming silicon dioxide atop a silicon wafer. Local oxidation, for example, is another common technique. This technique provides for selective oxide growth on a wafer and may be employed in, for example, NMOS, CMOS, and bi-polar technology. In local oxidation, a masking material, for example, silicon nitrate (Si₃N₄) is layered atop the silicon wafer. Thereafter, the wafer surface is subjected to oxidation conditions. The oxidation occurs only on the exposed surfaces of the silicon wafer not covered by the silicon nitride, thus, forming a desired geographical/topographical configuration.

When a desired geographic/topographic configuration of the wafer has been obtained, the wafer is fixed with appropriate conductive paths and connections. Those conductive paths and connections may be formed in a variety of manners, for example, by deposition, diffusion, implantation, and other techniques. In deposition, materials are selectively layered atop the wafer either by chemical or physical means. Chemical means are common for depositing polycrystalline silicon to form gates and connections of the silicon semi-conductor device. Diffusion, on the other hand, is a process which allows dopant atoms, for example, of boron, phosphorous, arsenic, or antimony, to move within the solid silicon of the wafer. The diffusion process occurs at an elevated temperature where there is a concentration gradient between dopant atoms external to the silicon wafer and dopant atoms diffusing into the silicon wafer and is typically employed when forming P-type and N-type regions of a silicon semi-conductor device. In another technique, implantation, electrically neutral dopant atoms are converted into ions and caused, by a collimated ion beam, to accelerate to gain high kinetic energy. These high energy ions are directed toward the silicon wafer and thereby caused to be implanted in a localized manner at a desired depth within the silicon of the wafer. Zones, referred to as wells or tubs, of P or N type regions can be formed in existing P or N type regions by subsequent diffusion or implantations. A number of other techniques and combinations are also possible.

As previously alluded to herein, etching is a common technique employed at various stages of the silicon semi-conductor device manufacturing process. Various etching techniques may be employed. These techniques are characterized by their selectiveness for particular materials being etched and their degree of anisotrophy, i.e., anisotropic etching occurs in a single direction and isotropic etching occurs in all directions. Etching may be by chemical means, physical means, or a combination of those means. Further, etching may be either wet etching, i.e., etching takes place in a liquid, or dry etching, i.e., etching takes place in a gas. In any event, the objective in any etching process is appropriate removal of particular materials from the wafer without causing adverse damage to the wafer.

By means and particular ordering of these various steps of oxide growth, patterning, etching, deposition, diffusion, implantation, and other techniques, a desired configuration of a silicon semi-conductor device may be manufactured.

Read-only-memory (ROM) storage devices, programmable logic array (PLA) devices, and the like are just some of the types of silicon semi-conductor devices that can be manufactured utilizing the foregoing manufacturing processes and others. A mask programmable ROM storage device is a silicon semi-conductor device which is capable of storing various messages or data that are programmed (or "coded") into the device during manufacture of the device. These coded messages or data stored by the mask programmable ROM storage device cannot be changed after manufacture of the device is completed. In such a mask programmable ROM storage device, a ROM core of the device contains an array of transistors positioned in rows and columns. This row and column positioning of the ROM core is chosen as desired by design of the device, to store the pre-programmed message or data. These mask programmable ROM storage devices include a sensing scheme which in operation can determine the pre-coded message or data of the ROM core at specific locations, which locations are determined by column decode and row decode sections of the ROM storage device. These column decode and row decode sections receive address codes for evaluating the message or data stored at a specific location in the ROM core.

In manufacturing silicon semi-conductor devices comprising transistors, decisions are made, based on desired function and other considerations, regarding selective placement of transistors in particular substrates of the device. These decisions must be made at the step or stage of the manufacturing process in which a diffusion mask is first used in the process. The manufacturing step in which a diffusion mask is first used, typically, in the prior technology methods, occurs relatively early in the manufacturing process. Therefore, numerous steps of the manufacturing process must follow the first diffusion mask step, before a completed device is obtained. These numerous steps following the first diffusion mask step generally require significant time and manpower to complete.

Silicon semi-conductor device manufacturers are often faced with a predicament due to the numerous steps that follow the first diffusion mask step in the typical device manufacturing process. Those manufacturers do not want to stock large quantities of each type or design of silicon semi-conductor device that customers may wish to purchase. On the other hand, customers for those devices typically will require quick if not immediate delivery of a particular type or design of the device. The manufacturer's predicament has been that it can either stack substantial quantities of each type or design of the devices so that the manufacturer can make immediate delivery of any type or design to customers or the manufacturer can only deliver particular types or designs if given substantial lead time from placement of order to delivery. The substantial lead time is necessary because the manufacturer will, because of the manufacturing steps heretofore employed, have only workpieces in stock which have been passed through only those processing steps prior to a first diffusion mask step. This is because, as previously described, the first diffusion mask step of the silicon semi-conductor device manufacturing process is typically one of the earliest steps of the process. The selective manner in which that diffusion mask step is performed dictates the type or design of device obtained from the entire process.

Clearly, it would be an advantage in the art and technology to eliminate this predicament faced by silicon semi-conductor device manufacturers.

We will describe a silicon semi-conductor device workpiece at a late step or stage in the manufacturing process that may be completed through only a few additional processing steps as any of a wide variety of types or designs of device. Because the workpiece allows choice of type or design at a late step or stage in the silicon semi-conductor device manufacturing (as opposed to an early step or stage in the case of the prior technology), manufacturers can make quick delivery of a variety of types or designs of device and, yet, need not stock all of those types or designs. The manufacturer instead need only maintain stocks of the workpiece according to the present invention and need only perform a minimal number of processing steps with the workpiece in accordance with the present invention to obtain desired types or designs of silicon semi-conductor devices.

One embodiment of the invention is an array of transistors of a semi-conductor device. The array comprises a substrate having a plurality of columns of implants formed therein, and an insulative layer covering the substrate. Rows of gate material are enclosed within the insulative layer and positioned relative to the implants in the substrate to form an array of transistors. Each of the transistors in a particular column share an implant with each adjacent transistor in that column, thereby electrically connecting the transistors in a column in a series arrangement. Windows are formed within the insulative layer, which windows allow metal layer paths to electrically connect with the implants of the transistors in the array. Metal layer jumpers electrically connect selected metal layer paths which are electrically connected to the implants of select transistors, thereby shorting out the select transistors in select row and column locations of the array of transistors.

Another embodiment of the invention is a method of forming an array of transistors. One step in the method is providing a semi-conductor workpiece having a substrate with a plurality of columns of implants, an insulative layer over the substrate and implants therein, and a plurality of rows of gate material positioned over the implants so as to form transistors at each position in the array, wherein each transistor in a particular column is electrically connected in series. Another step in the method Is forming a contact window in the insulative material covering the implants. Yet another step in the method is forming metal layer paths on the insulative layers which pass through the contact windows and electrically connect with the implants therebelow. Yet another step in the method is forming a metal layer jumper for each transistor to be shorted, which metal layer jumper electrically connects the metal layer paths that are electrically connected to the implants of a transistor to be shorted.

For a more complete understanding of the present invention, and for further features and advantages thereof, reference may now be had to the following detailed description, taken in conjunction with the accompanying drawings, wherein:
FIG. 1 is a schematic illustration of a ROM storage device circuit, including a NAND configuration ROM core circuit;
FIG. 2 is a partial cross-sectional view of a NAND configuration ROM core of a prior art mask programmable ROM storage device, said partial cross-section being taken along a sectional line of an imaginary silicon semi-conductor device, said line being functionally equivalent to the column 1 of the NAND configuration ROM core circuit in FIG. 1;
FIG. 3 is a partial cross-sectional view of an embodiment of a NAND configuration ROM core of a mask programmable ROM storage device, according to the present invention, said partial cross-section being taken along a sectional line of an imaginary silicon semi-conductor device, said line being functionally equivalent to the column 0 of the NAND configuration ROM core circuit in FIG. 1;
FIG. 4 illustrates a mask work which may be used in manufacture of a prior art silicon semi-conductor device having a partial cross-section like that shown in FIG. 2; and
FIG. 5 illustrates a mask work which may be used in manufacture of a silicon semi-conductor device having a partial cross-section like that shown in FIG. 3.

References herein to columns and rows refer to imaginary coordinates of a grid having intersections at positions where transistors could be located in either a schematic of an electric circuit or a silicon semi-conductor device which functions as the electric circuit. References herein to nodes refer to electrical connections between points in either a schematic of an electric circuit or a silicon semi-conductor device which functions as the electric circuit.

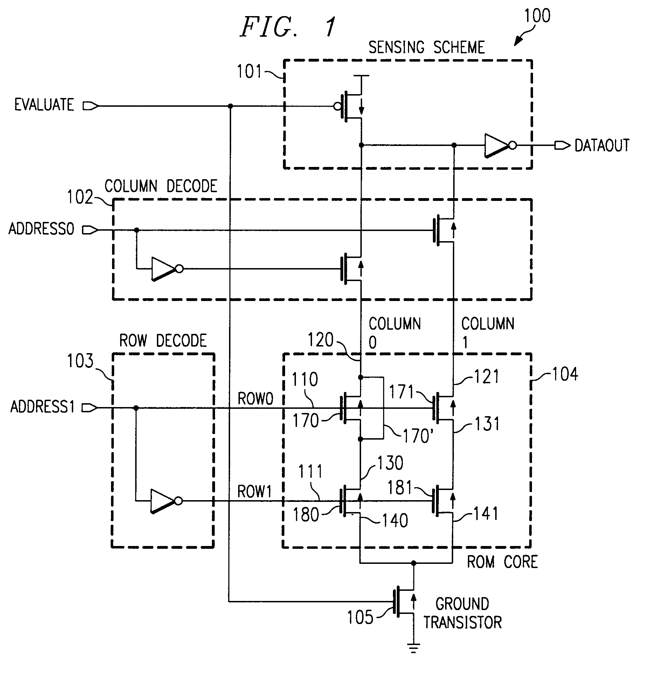

Referring first to FIG. 1, there is shown a schematic of a circuit 100 that functions as a read-only-memory (ROM) storage device, for example, such as a mask programmable ROM storage device which is a silicon semi-conductor device. The ROM storage device circuit 100 comprises a sensing scheme circuit 101, a column decode circuit 102, a row decode circuit 103, a NAND configuration transistor array referred to herein as a NAND configured ROM core 104, and a ground transistor 105. The circuits 101, 102, 103, NAND configured ROM core 104, and ground transistor 105 are electrically connected in a desired manner to function as a ROM storage device circuit 100. That is, the circuit 100 operates to receive an Evaluate command indicative of a specific storage Address of the circuit 100. In response to that Evaluate command, the circuit 100 outputs a predetermined data message stored at the specific storage Address of the circuit 100. The specific data messages for the various storage Addresses are programmed in the NAND configuration ROM core 104. If the circuit 100 is implemented as a silicon semi-conductor device, the data messages are programmed in the NAND configuration ROM core 104 at an early stage or step of the device manufacturing process.

Still referring to FIG. 1, the standard NAND configuration ROM core 104 of the prior art typically is an array of transistors. The transistors of the array are arranged in columns and rows. The transistors in a particular column of such an array are electrically connected in series from the drain of one transistor in a column to the source of the next, adjacent transistor. The transistors in a particular row of such an array are electrically connected gate to gate, each transistor in a row of the array being connected by its gate to the gate of adjacent transistors in the row. In FIG. 1, the ROM core 104 includes transistors 170, 171, 180, and 181 arranged in just such a column and row array as that described. A row 0 node 110 electrically connects to the gates of the transistors 170 and 171. A row 1 node 111 electrically connects to the gates of the transistors 180 and 181. A column 0 node 120 electrically connects the column decode circuit 102 to the drain of the transistor 170, a column 0 node 130 electrically connects the source of the transistor 170 to the drain of the transistor 180, and a column 0 node 140 electrically connects the source of the transistor 180 to the drain of the ground transistor 105. A column 1 node 121 electrically connects the column decode circuit 102 to the drain of the transistor 171, a column 1 node 131 electrically connects the source of the transistor 171 to the drain of the transistor 181, and a column 1 node 141 electrically connects the source of the transistor 181 with the drain of the ground transistor 105. Although the transistors 170, 171, 180 and 181 in FIG. 1 are N-type transistors in a silicon semi-conductor device that implements the circuit 100, they could be P-type transistors or other devices of such a silicon semi-conductor device. (If P-type transistors are used in the ROM core 104, the sensing scheme circuit 101, the column decode circuit 102, the row decode circuit 103, and ground transistor of the ROM storage device 100 must be modified from that of FIG. 1 in order to accommodate the P-type transistors in the ROM core 104.)

Continuing to refer to FIG. 1, this standard NAND configuration ROM core 104 of a silicon semi-conductor device can be programmed during the device manufacturing process by employing a jumper to electrically connect the source and drain of select transistors in the ROM core 104, thereby shorting out those transistors. By this shorting of select transistors of the ROM core 104, a select message or data is programmed. The circuit 100 will output a particular message or data dependent upon which transistors of the ROM core 104 are shorted. As an example in FIG. 1, only transistor 170 is shorted. As shown, a jumper 170' electrically connects the drain and source of transistor 170. This exemplary ROM storage device circuit 100, thus, operates by outputting the data or message stored at a particular Address, which particular Address is selected by the input Evaluate command, the specific data or message output by the circuit 100 being dictated by the jumper 170' arrangement of the ROM core 104 of the circuit 100.

Still referring to FIG. 1, it can be seen how the ROM core 104 provides a unique data message for each Address indicated by an input Evaluate signal. In column 0, the jumper node 170' allows electrical conduction between the nodes 120 and 130 regardless of the state for the row 0 node 110. However, the transistor 180 in column 0 will only conduct between the nodes 130 and 140 if the row 1 node 111 is high. Therefore, the column 0 node 120 will only electrically conduct to the node 140 when the row 1 node 111 is high, regardless of the state of the row 0 node 110. In column 1, the transistor 171 will only conduct between the nodes 121 and 131 if the row 0 node 110 is high. Furthermore, the transistor 181 in column 1 will only conduct between the nodes 131 and 141 if the row 1 node 111 is high. Therefore, the column 1 node 121 will only electrically conduct to the node 141 if both the row 0 node 110 and the row 1 node 111 are high. In this manner, the column 0 will have a conductive state between nodes 120 and 140, and column 1 will have a conductive state between nodes 121 and 141, as shown in Table 1 for each combination of states for row 0 node 110 and row 1 node 111.

**TABLE 1**

| ROW 0 | ROW 1 | COLUMN 0 | COLUMN 1 |
|---|---|---|---|
| LOW | LOW | NOT CONDUCT | NOT CONDUCT |
| HIGH | LOW | NOT CONDUCT | NOT CONDUCT |
| LOW | HIGH | CONDUCT | NOT CONDUCT |
| HIGH | HIGH | CONDUCT | CONDUCT |

Referring still to FIG. 1, it can be seen how the ROM storage device circuit 100 utilizes the ROM core 104 to produce a unique data out message for each Evaluate input command given a specific Address. Prior to receiving an Evaluate command, the gate of the ground transistor is held low and no electrical connection is completed between ground and the nodes 140 or 141, and the sensing scheme is pre-charged. When an Evaluate command is sent to the ROM storage device 100, the MUX line is disconnected from the power source pre-charging the MUX line and the gate of the ground transistor goes high causing an electrical connection from ground to the nodes 140 and 141. The column decode 102 selects the column for reading, depending on whether the Address 0 sent with the Evaluate command is high or low. Also, the row decode 103 will cause one of the row lines to go high and the other of the row lines to go low. Whichever of the row lines is high (and the other row line low) will depend on whether the Address sent with the Evaluate command is high or low. Transistors on a row line, which line is low, will not electrically conduct between the source and the drain of the transistor. Transistors on a row line, which line is high, will electrically conduct between the column nodes connected and to the source and the drain of the transistor. Therefore, for a column of the ROM core 104 to be conductive, the transistors connected and contained in that column must either be located at a row line which is high or electrically shorted by an electrically conductive jumper from the drain of the transistor to the source of the transistor. If the selected column is conductive, the pre-charge in the MUX will drain through the selected column and the ground transistor 105, and the data out will be high. If the selected column is not conductive, the MUX will remain charged and the data out will be low. Table 2 illustrates the programming of the ROM storage device circuit 100 in FIG. 1, having the ROM core 104.

**Table 2**

| ADDRESS 0 | ADDRESS 1 | DATAOUT |
|---|---|---|
| 0 | 0 | 1 |
| 1 | 0 | 0 |
| 0 | 1 | 0 |
| 1 | 1 | 0 |

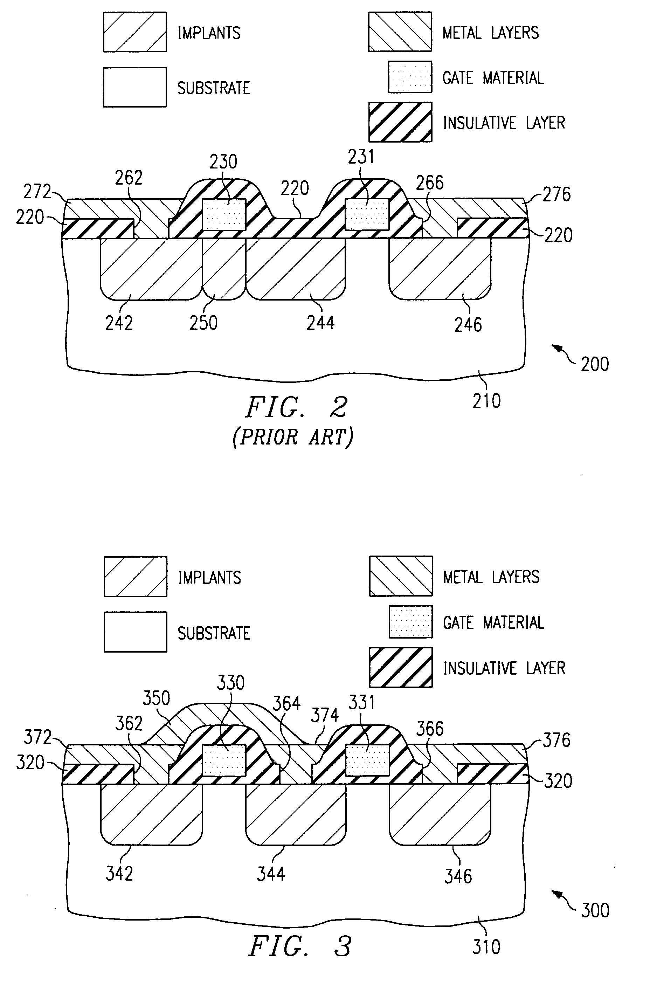

Referring now to FIG. 2, there is shown a partial cross sectional view of a prior art semi-conductor device, indicated generally at 200, that performs the functions of the circuit 100. The cross section is taken at a sectional line for the area of the semi-conductor device which performs the functions of the column 0 in FIG. 1. The semi-conductor device 200 in FIG. 2 comprises a substrate 210 having diffusion implants 242, 244, and 246, and depletion implant 250 formed therein. The substrate 210 can be wells of P-type or N-type material in the semi-conductor device 200, or can be the entire semi-conductor device 200 formed of either P-type or N-type material. To form N-type transistors, the substrate is a P-type material and the implants are an N-type material. However, P-type transistors can be formed by reversing the type of materials used in forming the substrate and implants. An oxide or resistance layer 220 covers the substrate and contains the polycrystalline gates 230 and 231. The implants 242 and 244 align underneath the gate 230 to form a transistor, and the implants 244 and 246 align below the gate 231 to form a second transistor. The implant 250 electrically connects the implant 242 to the implant 244. A metal layer path 272 covers a portion of the oxide layer 220 and passes through a window 262 in the oxide layer 220 for electrically connecting to the implant 242 in the substrate 210. A second metal layer path 276 covers a different portion of the oxide layer 220 and passes through a second window 266 for electrically connecting to the implant 246.

Referring now to FIGS. 1 and 2 in combination, it can be seen how the prior art semi-conductor device 200 operates to perform the functions of column 0 in the ROM core 104 of the circuit 100 of FIG. 1. The implant 242 and the implant 244 of FIG. 2, act as the drain and the source, respectively, of the transistor 170 in FIG. 1. The gate material 230 in FIG. 2 acts as the gate of the transistor 170 in FIG. 1. The implant 244 and the implant 246 of FIG. 2, act as the drain and the source, respectively, of the transistor 180 in FIG. 1. The gate material 231 in FIG. 2 acts as the gate of the transistor 180 in FIG. 1. The metal layer path 272 and the metal layer path 276 of FIG. 2 act as the node 120 and the node 140, respectively, in FIG. 1. The implant 244 of FIG. 2 also acts as the node 130 in FIG. 1. Furthermore, the implant 250 in FIG. 2 acts as the jumper 170' in FIG. 1.

Still referring to FIGS. 1 and 2 in combination, the intersection of column 0 and row 0 of the circuit in FIG. 1 is represented by the area around and below the gate 230 of the partial cross section of the semi-conductor device 200 in FIG. 2. As previously noted, the implant 250 acts as the jumper 170' in FIG. 1 and electrically connects the implant 242 with the implant 244. Therefore, the implant 242 will always conduct to the implant 244, regardless of whether the gate 230 is high or low. The intersection of column 0 and row 1 is represented by the area around and below the gate 231. As previously noted, the implant 244, the implant 246, and the gate 231 form a transistor. Therefore, when the gate 231 is low and does not influence the substrate 210, no conductive connection will be formed between the implant 244 and the implant 246. However, when the gate 231 is high and so does influence the substrate 210, a conductive connection is formed between the implant 244 and the implant 246. The influence upon the substrate 210 by the gate 231 to connect the implant 244 with the implant 246 performs the same functions as the transistor 180 in the ROM core 104 of the circuit 100 of FIG. 1. From the foregoing, it can be seen that by controlling the diffused area of implants, the prior art silicon device 200 forms transistors at column and row locations and selectively shorts those transistors, enabling programming of the ROM core 104 of the ROM storage device circuit 100.

Referring now to FIG. 3, there is shown a partial cross-sectional view of an embodiment of a semi-conductor device of the present invention, indicated generally at 300, that performs the functions of the circuit 100. The said cross-section is taken at a sectional line for the area of the semi-conductor device which performs the functions of the column 0 in FIG. 1. The semi-conductor device 300 in FIG. 3 includes a substrate 310 with implants 342, 344, and 346 formed therein. The substrate 310 can be wells of P-type or N-type material in the semi-conductor device 300, or can be the entire semi-conductor device 300 formed of either P-type or N-type material. To form N-type transistors, the substrate is a P-type material and the implants are an N-type material. (P-type transistors (or other devices) could also be formed by reversing the type of materials used in forming the substrate and implants (or otherwise)). Covering the substrate 310 is an oxide or insulative layer 320. Within the oxide or protective layer 320 are gates 330 and 331. The implants 342 and 344 align beneath the gate 330 to form a first transistor, and the implants 344 and 346 align beneath the gate 331 to form a second transistor.

Still referring to FIG. 3, a metal layer path 372 covers a portion of the oxide layer 320 and passes through a window 362 in the oxide layer 320 to form an electrical connection with the implant 342 in the substrate 310. A second metal layer path 374 covers a second portion of the oxide layer 320 and passes through a window 364 in the oxide layer 320 to form an electrical connection with the implant 344. A third metal layer path 376 covers a third portion of the oxide layer 320 and passes through a window 366 in the oxide layer 320 to form an electrical connection with the implant 346. A metal layer jumper 350 electrically connects the metal layer path 372 with the metal layer path 374. Although the metal layer paths 372, 374, and 376 are illustrated as separate layers, these paths could represent separate paths of one single layer. Furthermore, the metal layer jumper 350 could be part of the layer, or layers, forming the metal layer paths 372, 374, or 376.

Referring now to FIGS. 1 and 3 in combination, the intersection of column 0 and row 0 in the circuit 100 of FIG. 1 is represented in the semi-conductor device 300 in FIG. 3 by the area around and below the gate 330. Because the implants 342 and 344 are aligned beneath the gate 330, a transistor exists in the semi-conductor device 300 at an area representing the intersection of row 0, column 0. However, the metal layer jumper 350 forms an electrical connection between the implant 342 and the implant 344 through the metal layer paths 372 and 374, respectively. Therefore, although a transistor has been formed in the semi-conductor device 300 in the area of the intersection of column 0 and row 0, the metal layer jumper 350 and the metal layer paths 372 and 374 will short out the transistor and always provide a conductive path between the implant 342 and the implant 344.

Still referring to FIGS. 1 and 3 in combination, the intersection of column 0 and row 1 in the circuit 100 of FIG. 1 is represented in the semi-conductor device 300 in FIG. 3 by the area around and below the gate 331. Because the implant 344 and the implant 346 have been formed to align below the gate 331, a transistor exists in the semi-conductor device 300 at an area represented by the intersection of column 0 and row 1. Therefore, when the gate 331 is low, there is no influence on the substrate 310 and no conductive path electrically connecting the implant 344 with the implant 346. However, when the gate 331 is high and acts upon the substrate 310 there beneath, the substrate 310 provides an electrically conductive path between the implant 344 and the implant 346.

Referring still to FIGS. 1 and 3 in combination, it can be seen how the components of the semi-conductor device 300 in FIG. 3 act as the corresponding components of the ROM core 104 of the ROM storage device circuit 100 in FIG. 1. The implant 342 and the implant 344 in FIG. 3 act as the drain and the source, respectively, of the transistor 170 in FIG. 1. The gate 330 in FIG. 3 acts as the gate of the transistor 170 in FIG. 1. The implant 344 and the implant 346 in FIG. 3 act as the drain and the source, respectively, of the transistor 180 in FIG. 1. The gate 331 in FIG. 3 acts as the gate of the transistor 180 in FIG. 1. The metal layer path 372 and the metal layer path 376 in FIG. 3 act as the node 120 and the node 140, respectively, in FIG. 1. The implant 344 in FIG. 3 also acts as the node 130 in FIG. 1. Furthermore, the metal layer paths 372 and 374, with the metal layer jumper 350, act as the jumper node 170' in FIG. 1.

Still referring to FIGS. 1 and 3 in combination, it can be seen how the semi-conductor device 300 operates to perform the functions of column 0 in the ROM core 104 of the circuit 100 in FIG. 1. When both the gates 330 and 331, acting as row 0 node 110 and row 1 node 111, respectively, are low, there is no conductivity between the metal layer paths 372 and 376, acting as nodes 120 and 140, respectively. When the gate 330 is high and the gate 331 is low, there is no conductivity between the metal layer paths 372 and 376. When the gate 330 is low and the gate 331 is high, there will be conductivity between the metal layer paths 372 and 376 due to the metal layer paths 372 and 374 and the metal layer jumper 350 acting as the jumper 170'. Also, when both of the gates 330 and 331 are high, there will be conductivity between the metal layer paths 372 and 376. From the foregoing it can be seen that the gates 330 and 331 control the conductivity between metal layer paths 372 and 376 in the same manner as the row 0 node 110 and the row 1 node 111 control the conductivity between the column 0 node 120 and the column 0 node 140, and as reflected in column 0 of Table 1.

Still referring to FIGS. 1 and 3 in combination, it can be seen how an array of transistors with a pre-programmed message may be formed according to the present invention. Multiple transistors are formed in an array having columns and rows. The gates for each transistor in a particular row are connected so that the gates for all transistors in the particular row are simultaneously all high or all low. Each transistor in a particular column shares an implant with an adjacent transistor in the same column, thereby connecting the transistors in a particular column together in series. For each implant, a metal layer path passes through a window in an insulative material covering the implants and electrically connects to the implant. The metal layer paths connected to the implants of select transistors are electrically connected by metal layer jumpers. The choice of particular transistors which are selectively connected with the metal layer jumpers is made based on the desired preprogrammed message stored by means of the array. If the desired preprogrammed message requires that the conductivity of a particular column not be dependent on the status of a particular row, a metal layer jumper is used on the transistor at that particular column and row. However, if the desired preprogrammed message requires that the conductivity of a particular column be dependent on the status of a particular row, no metal layer jumper is used on the transistor at that particular column and row. In this manner, the various columns of the array will have a conductive state that is dependent on the status of the various rows and the existence of jumpers on select transistors. This relationship of column conductivity state to row status and jumper location is the preprogrammed message of the transistor array. From the foregoing, it can be seen that a transistor array may be programmed by virtue of the ROM core 104 of a silicon semi-conductor device functioning as the ROM storage device circuit 100.

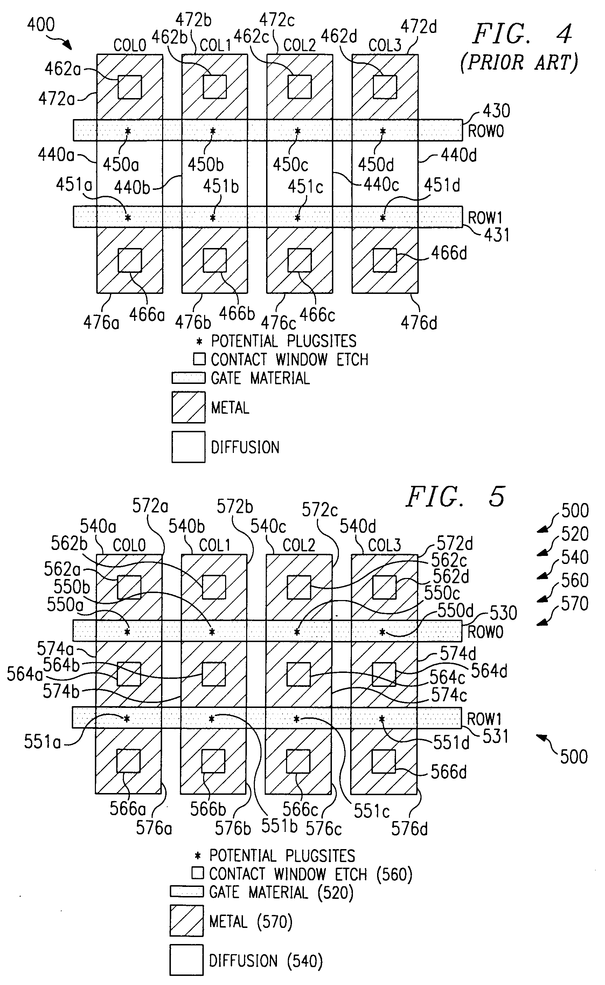

Referring now to FIG. 4, there is shown a prior art mask work indicated generally at 400. The mask work 400 is the type heretofore used in the manufacturing process for producing the semi-conductor device 200 of FIG. 2. The manufacture of a semi-conductor device 200 using the prior art mask work 400 is initiated with a wafer workpiece which is treated to have a desired substrate, either P-type or N-type. Because the transistors formed in the particular semi-conductor device 200 illustrated in FIG. 2 are N-type transistors, the substrate 210 for the semi-conductor device 200 is a P-type substrate. Following treatment of the substrate, depletion implants are located in the substrate at select locations for shorting specific transistors later formed in the silicon semi-conductor device through the prior art manufacturing process. To form the depletion implants, depletion plugs are located at select ones of a plurality of potential plugsites 450a-d and 451a-d, which plugsites represent possible row and column locations for jumpers which can serve to short transistors at those locations. Using the depletion mask having the depletion plugs at select ones of the potential plugsites 450a-d and 451a-d, depletion implants are made by doping the depletion mask region with appropriate atoms as desired for the application. In the semi-conductor device 200 of FIG. 2, the implants are doped so that the depletion implants will be an N-type area within the P-type substrate 210. After the depletion implants are formed, an insulative layer, such as an oxide layer, is formed over the substrate and depletion implants therein.

Still referring to FIG. 4, the next step in this prior method of manufacturing a silicon semi-conductor device 200 is typically a diffusion mask and gate mask step. This diffusion mask and gate mask step forms transistors in the silicon semi-conductor device 200. To form the transistors, the diffusion mask is first employed to reduce the thickness of the oxide layer in the diffusion mask areas 440a-d. The gate mask is then utilized to place a layer of the polycrystalline gate material on top of the oxide of the silicon device 200 in the areas represented by the gate mask areas 430 and 431. Following placement of the gate material, the diffusion mask is employed again to allow etching away of the remaining oxide layer in the diffusion mask areas 440a-d, and to promote diffusion in the diffusion mask areas 440a-d. It should be noted that the gate material layer previously applied will not be etched away and diffusion will occur at the periphery of each side below the gate material, but not directly below the gate material. Areas in the substrate below the diffusion mask are doped with appropriate atoms as desired for the application, forming the implants within the substrate. In the semi-conductor device 200 of FIG. 2, the implants have been doped so that the implant areas 242, 244, and 246 will be an N-type area within the P-type substrate 210. Following employment of the diffusion mask to form the implant areas, the oxide layer is increased across the top of the semi-conductor layers. This oxide layer serves to protect the implant areas and gate material.

Continuing to refer to FIG. 4, next in the manufacturing process a contact window mask, having contact window areas 462a-d and 466a-d, is placed atop the oxide layer. This contact window mask is employed in removing substantially all of the oxide layer in the areas represented by the contact window areas 462a-d and 466a-d. Once the oxide has been removed to reveal these contact window areas 462a-d and 466 a-d, a metal mask is employed for forming metal layer paths across the top surface of the workpiece. The metal mask has window areas 472a-d and 476a-d. Because the contact window areas 462a-d and 466a-d were etched, providing passage through the oxide layer to the implants in the substrate, the metal layer paths formed across the workpiece electrically connect to those implants.

Referring now to FIGS. 2 and 4 in combination, it may be seen that the mask 400, generally employed as described above, forms the semi-conductor device 200. The decision of where geographically to form jumpers in such a semi-conductor device 200 is made during those steps in which the depletion mask is employed. As an example in this described manufacturing process, the depletion mask for column 0 will have only one depletion plug located at potential plugsite 450a. No depletion plug is inserted at potential plugsite 451a. In this manner, the implant areas 242 and 244 form below the diffusion mask area 440a on either side at the periphery of the gate mask area 430, and a transistor is formed in the area of row 0 column 0. Also, the implant areas 244 and 246 form below the diffusion mask area 440a on either side at the periphery of the gate mask area 431, and a transistor is formed in the area of row 1 column 0. However, in the area of row 0, column 0, the depletion plug at potential plugsite 450a forms the implant 250 which will electrically conduct between the implants 242 and 244. Therefore, although a transistor has been formed at row 0 column 0 of the device 200, the implant 250 may act as the jumper 170', shorting the transistor. In contrast, at potential plugsite 451a there will be no depletion plug, and therefore no implant for electrically conducting between the implants 244 and 246. Therefore, the transistor formed at row 1 column 0 by implants 244 and 246 may not be shorted by a jumper. From the foregoing, it is seen that the process of selectively determining plug locations through the design of the depletion mask is repeated for each column of the semi-conductor device 200, so that only transistors at desired intersections of the rows and columns are shorted by implants acting as jumpers. However, determination of where to locate plugs must be made at the stage of the manufacturing process in which the depletion mask is employed. That is typically one of the earliest stages (i.e., steps) of the manufacturing process for a semi-conductor device 200.

Referring now to FIG. 5, there is shown a mask work, indicated generally at 500, which may be employed in forming the silicon semi-conductor device 300 in FIG. 3. The mask work 500 generally comprises a diffusion mask 540, a gate mask 520, a contact window mask 560, and a metal layer mask 570. The diffusion mask 540 has diffusion mask areas 540a-d. The gate mask 520 has gate mask areas 530 and 531. The contact window mask 560 has contact window mask areas 562a-d, 564a-d, and 566a-d. Finally, the metal layer mask 570 has metal layer path areas 572a-d, 574a-d, and 576a-d, and potential plugsites 550a-d and 551a-d for locating metal layer plugs.

Now referring to FIGS. 3 and 5 in conjunction, a manufacturing process in which the mask work 500 is employed is initiated by a step of treating a silicon wafer workpiece to form a desired substrate, either P-type or N-type. The substrate may be treated across the entire surface of the semi-conductor device or, alternatively, areas, or small pockets, of the device may be treated. These pockets are wells or tubs. Furthermore, P-type or N-type wells may be formed in areas of the workpiece which have already been treated to form N-type or P-type material areas. Because the transistors formed in the semi-conductor device 300 of FIG. 3 are N-type transistors, the substrate 310 for the semi-conductor device 300 is a P-type substrate. After a substrate has been treated as desired for the application, an insulating layer, such as an oxide layer, may be formed across the surface of the substrate.

Continuing to refer to FIGS. 3 and 5 in conjunction, a next step in a manufacturing process in which the mask work 500 is employed may be to form transistor gates and implants. In the manufacturing process, the diffusion mask 540 of the mask work 500 is preferably first employed in reducing the insulative layer thickness in the diffusion mask areas 540a-d. The gate mask 520 of the mask work 500 may be employed in placing a layer of gate material, such as polycrystalline silicon, in gate mask areas 530 and 531. Following placement of such gate material, the diffusion mask 570 may be employed in an etch procedure of selectively etching away the insulative layer and a diffusion procedure involving the substrate at the diffusion areas 540a-d. It should be noted that the gate material layer is not etched away and causes the diffusion to occur on either side of the periphery below the gate material, but not directly below the gate material. In the semi-conductor device 300 of FIG. 3, the implants are doped so that the implant areas 342, 344, and 346 are N-type areas within the P-type substrate 310. (When forming P-type transistors, however, it is possible to dope the existing N-type substrate so that the implant areas become a P-type area.) A new layer of insulative material is then placed over the entire area protecting the gate material and the exposed substrate and implants therein. At this stage in the manufacturing process, a transistor has been formed at every row and column intersection of the workpiece.

Still referring to FIG. 5, a next step in the manufacturing process in which the mask work 500 is employed, may be to determine which transistors of the array must be shorted in order to pre-program the transistor array with a desired message or data considering the status of each row. Employing the principles herein with reference to FIG. 1 and Tables 1 and 2, it may be determined which transistors in the array must be shorted. As an example of the determination, a table illustrating the conductivity states of columns in the transistor array for each combination of row conditions, such as Table 1, may be created for the particular circuitry of the device that includes the transistor array. The table will be dictated by particular, desired data output requirements of the device for each Address of the device. Where the table indicates that a column must be conductive for a particular combination of row states, the rows in that particular combination must be either high or a jumper must exist which shorts the transistor at that row and column location. Therefore, a metal layer jumper must be located at a row and column location where the column must have a conductive state when the particular row has a low state. It may be seen that by reviewing a table illustrating the conductive states of each column for various combinations of row states, it may be determined where metal layer jumpers should be located in the array of transistors. Use of such a table is only one method for determining appropriate jumper locations and is not intended to limit the present invention to only that method for determining appropriate jumper locations. Furthermore, although the step of determining appropriate jumper locations is illustrated herein as following subsequent to a step of forming transistor gates, implants, and insulative layer, a step of determining appropriate jumper locations could alternatively be performed at any step of the method prior to forming the metal layer jumpers.

Continuing to refer to FIG. 5, a next step in the manufacturing process in which the mask work 500 may be employed may be etching of contact windows in the insulative layer over the implants to facilitate placement of metal layer paths across the semi-conductor device workpiece. The contact window mask 560 of the mask work 500 may be utilized to remove, for example, substantially all of the insulative layer in the areas represented by the window mask areas 562a-d, 564a-d, and 566a-d. Following formation of the contact windows in the insulative layer, the metal layer paths may be formed across the insulative layer. The metal layer mask 570 may be utilized in placing metal layer paths on the insulative layer, which metal layer paths may pass through the contact windows and electrically connect with the implants in the substrate.

Further referring to Fig. 5, a next step in a manufacturing process employing the mask work 500 may be to form desired metal layer jumpers. A plurality of potential plugsites 550a-d and 551a-d may be located at the row and column intersections. These potential plugsites 550 a-d and 551 a-d indicate locations in the metal layer mask 570 for metal layer jumpers. If a metal layer plug is formed at any particular potential plugsite, a metal layer jumper is formed which electrically connects the metal layer paths at that particular potential plugsite, thereby shorting the implants of the transistor at that row and column location. For example, when it is desired to place a jumper between the implants of a transistor at row 0 column 0, a metal layer plug is formed at the potential plugsite 550a of the metal layer mask 570. Therefore, though a transistor may potentially exist in the workpiece at the intersection of row 0 and column 0, a metal layer jumper electrically connects the implants of the transistor, thereby shorting that transistor and, in effect, eliminating any effect of that transistor.

Further referring to FIG. 5, the metal layers of the workpiece are preferably formed in a single simultaneous operation utilizing the metal layer path mask areas 572a-d, 574a-d, and 576a-d to form the metal layer paths and the metal layer plugs, each at selected ones of the potential plugsites 550a-d and 551a-d. In this manner, desired metal layer jumpers may be formed at select locations. The metal layer could, however, be formed in two operations, rather than one. In that instance, a first operation utilizes metal layer mask areas 572a-d, 574a-d, and 576a-d to form the metal layer paths on the insulative layer and a second operation utilizes metal layer plugs at the select ones of the potential plugsites 550a-d and 551a-d to form the metal layer jumpers. This first and second operation of the two operation method for forming the metal layers may be performed at distinct times in the process.

Referring now to FIGS. 3 and 5 in combination, the mask 500 may be employed generally as described above in forming the semi-conductor device 300. By employing the mask 500 in this manner, a decision of where to locate jumpers need not be made until performing the steps of the manufacturing process in which the metal layer mask 570 of the mask work 500 is employed. As an example, the gates 330 and 331 for column 0 of the semi-conductor device 300 may be formed under the gate mask areas 530 and 531, and the implants 342, 344, and 346 may be formed under the diffusion mask area 540a. The window mask 560 may form contact windows 362, 364, and 366 in the oxide layer 320 at window mask areas 562a, 564a, and 566a. The metal layer mask 570 for column 0 of the semi-conductor device 300 may have the standard metal layer path areas 572a, 574a, and 576a which may form the metal layer paths 372, 374, and 376 that pass through the windows 362, 364, and 366, and electrically connect to the implants 342, 344, and 366. The metal layer mask 570 may have only one metal layer plug for column 0 of semi-conductor device 300 at the potential plug site 550a. No metal layer plug may be inserted into the potential plugsite 551a. In this manner, the metal layer jumper 350 may be formed at potential plugsite 550a and will thereby electrically connect the metal layer paths 372 and 374. Therefore, although a transistor has been formed at row 0 column 0, the metal layer jumper 350 may conduct through the metal layer paths 372 and 374 to electrically connect the implants 362 and 364, thereby shorting the transistor at row 0 column 0. In contrast, at the potential plugsite 551a there may be no metal layer plug, and therefore no jumper to electrically connect the implants 344 and 346 of the transistor at row 1 column 0. From the foregoing it can be seen that the process of selectively determining plug locations for the metal layer mask 570 may be repeated for each column of the semi-conductor device 300 so that only transistors at particular, desired intersections of specific rows and columns are shorted by metal layer jumpers electrically connecting the implants of the transistors.

Referring now to FIGS. 2-5 in combination, the advantages of the present embodiment may be illustrated In manufacturing the prior art semi-conductor device 200 of FIG. 2, depletion implants are used to form jumpers that electrically short out transistors at specific row and column locations. Because the steps of forming these jumpers may require changes in the depletion mask of the mask work 400 in order to obtain the desired semi-conductor device 200 from the process, and because the depletion mask must be used in an early stage of the process, any decision about where on the device to place the implants is necessarily based on unique customer requirements. To fulfill those requirements, necessary actions must be taken at early stages (or steps) of the manufacturing process for these devices. Therefore, each time that a customer places an order for a semi-conductor device having a unique transistor array, such as a ROM storage device, the product semi-conductor device to be delivered to the customer must be processed through many stages, from changing the depletion layer through a final stage of placing a metal layer across the top surface. Because many processing steps must be left for completion after a customer places an order, this prior art manufacturing process presents the manufacturer with the predicament previously described.

In contrast, by virtue of the described embodiment of the present invention fewer steps are needed to process a workpiece from initial stage to final product. This is because in manufacturing the semi-conductor device 300 according to the described method metal layer jumpers may be employed to electrically short transistors at specific row and column locations. This method of forming jumpers for specific transistors is performed in the later stages or steps of the manufacturing process, which steps are those in which a metal layer mask 570 of the mask work 500 is employed. Those steps occur later in the overall manufacturing process. As a result, the described method allows the manufacturer to process the workpiece to a later stage of the overall process, without the necessity of knowledge of unique customer requirements. Partially completed semi-conductor devices, may be stored until a customer places an order for devices meeting the customer's unique requirements. Once an order is placed, appropriate jumper locations for a transistor array may be determined according to the unique customer requirements. A contact window mask 560 can then be employed in forming contact windows in the oxide layer. Next, a metal layer mask 570 may be modified by placing metal layer plugs in desired potential plugsites of the workpiece in order to form jumpers which electrically short transistors located at specific row and column locations. This process allows a manufacturer to complete semi-conductor devices meeting a customer's unique requirements in a much shorter time (due to fewer remaining manufacturing process steps) after receipt of the order, in comparison with the prior art process semi-conductor which must be processed starting at an earlier stage of the manufacturing process once a customer order is received.

Additionally, the described method allows the manufacture of semi-conductor devices to proceed through steps of diffusion, gate material placement, oxide layers, window etching, and forming metal layer paths across the semi-conductor device 300 to obtain partially completed semi-conductor devices which need only be processed through a few additional steps to obtain final product devices. The partially completed semi-conductor devices may be stocked by the manufacturer until a customer places an order for devices having unique pre-programmed message requirements. At the time a customer places an order, jumper locations for the transistor array may be determined according to the customer's requirements. Metal layer plugs may then, in the previously described manner, be positioned at potential plugsites of the workpiece representing specific row and column locations for transistors to be shorted. The metal layer plugs create metal layer jumpers which electrically connect the implants of transistors, thereby electrically shorting those transistors. This process enables manufacturers to complete semi-conductor devices manufacture, including for devices meeting a customer's unique requirements, in fewer remaining steps and, thus, shorter time.

Based upon the foregoing, those skilled in the art will fully understand and appreciate the improvements exhibited by the teachings herein. Those skilled in the art will also understand and appreciate that various alternatives, additions, and modifications may be made in embodiments and, in particular, the preferred embodiment described herein. Further details of related systems, apparatus and products may be found in the related cases listed in the Cross-Reference to Related Applications section above. Although those related details are not necessary in every case for those skilled in the art to practice the present invention or to comprehend its best mode of practice, those details may be useful to those skilled in the art and reference to them may be desirable.

Numerous modifications and variations of the embodiments and, in particular, the preferred embodiment of the invention are possible in light of the teachings herein. For example, although the description has disclosed the use of an array of transistors in one possible embodiment of a ROM core, other transistor arrays or other arrangements may be used in other devices, such as, for example, a PLA, or the like. Each of these modifications and variations is intended to be included in the description herein and forms a part of the present invention. The foregoing detailed description is, thus, to be clearly understood as being given by way of illustration and example only, the scope of the present invention being limited solely by the appended claims.

## Claims

1. A semi-conductor device comprising:
a substrate having a plurality of implants in a column;
a plurality of rows of gate material, each row of gate material is positioned between two of the implants in said substrate, wherein a column of transistors are formed which share an implant with the adjacent transistors in the column;
an insulative layer covering said substrate and the implants therein, said insulative layer including a pair of contact windows therethrough to the implants in said substrate for a select transistor; and
a metal layer passing through the contact windows in said insulative layer and electrically connecting the implants in said substrate for the select transistor.

2. The semi-conductor as in claim 1, wherein:
said insulative layer includes a plurality of pairs of contact windows, each of said pairs of contact windows passing through said insulative material to the implants in said substrate for a select transistor; and
said metal layer having a plurality of jumpers, each of the jumpers passing through one of the pair of contact windows and electrically connecting the implants in said substrate for the select transistor.

3. The semi-conductor device as in claim 1 or claim 2, wherein:
said substrate has a plurality of columns of the implants; and
each row of the gate material is positioned between two of the implants in each column of implants in said substrate, wherein a plurality of columns of transistors are formed with each transistor in a column sharing an implant with the adjacent transistor in the same column.

4. An array of transistors in a semi-conductor device, comprising:
a substrate having a pluralrity of columns of implants formed therein;
an insulative layer covering said substrate and having a plurality of windows formed therethrough to the implants in said substrate;
a plurality of rows of gate material enclosed in said insulative material and positioned relative to the implants in said substrate to form an array of transistors, wherein each of the transistors in a particular column of the array share an implant with each adjacent transistor in the same column of transistors, thereby connecting the column of transistors in a series arrangement;
a plurality of metal layer paths, wherein each of said metal layer paths pass through one of the windows in said insulative material and electrically connect to the implant located therebelow in said substrate; and
a plurality of metal layer jumper paths which electrically connect the metal layer paths connected to the implants for a select one of said transistors at select row and column location.

5. The device as in claim 4, wherein either said substrate is a P-type material and said implants are a N-type material; or
said substrate is at least one well of a P-type material in said semi-conductor device, and said implants are a N-type material; or
said substrate is a N-type material and said implants are a P-type material; or
said substrate is at least one well of a N-type material in said semi-conductor device, and said implants are a P-type material.

6. A ROM core comprising:
a substrate having plurality of columns of implants formed therein;
an insulative layer covering said substrate and having a plurality of windows formed therethrough to the implants in said substrate;
a plurality of rows of gate material enclosed in said insulative material and positioned relative to the implants in said substrate to form an array of transistors, with each transistor in a particular column sharing an implant with each adjacent transistor in the same column;
a plurality of metal layer paths attached to said insulative layer, wherein said metal layer paths pass through the windows in said insulative material and electrically connected to the implants located therebelow; and
a metal layer jumper connecting the metal layer paths which are electrically connected to the implants of a select transistor.

7. The ROM core according to claim 6, wherein either said substrate is a P-type material, and said implants are a N-type material; or
said substrate is at least one well of a P-type material, and said implants are a N-type material; or
said substrate is a N-type material, and said implants are a P-type material; or
said substrate is at least one well of N-type material, and said implants are a P-type material.

8. An improvement in a ROM storage device having a ROM core, a row decode, a column decode, a sensing scheme, and a ground transistor the improvement comprising said ROM core having:
a substrate having a plurality of columns of implants therein, a first implant in each of said columns of implants being electrically connected to said column decode and an end implant in each of said columns of implants being electrically connected to said ground transistor;
an insulative layer covering said substrate and having a plurality of windows formed therethrough to the implants in said substrate;
a plurality of rows of gate material enclosed in said insulative material and positioned relative to the columns of implants in said substrate to form an array of transistors, each of said transistors in a column sharing an implant with each adjacent transistor in the same column, said rows of gate material further electrically connected to said row decode;
a plurality of metal layer paths attached to said insulative layer, each of said metal layer paths passing through one of the windows in said insulative material and electrically connecting with one of the implants located therebelow; and
a metal layer jumper connecting the metal layer paths which are electrically connected to the implants for a select transistor.

9. The device as in claim 8, wherein either said substrate or said ROM core is a P-type material, and said implants of said ROM core are a N-type material; or
said substrate of said ROM core is at least one well of a P-type material, and said implants of said ROM core are a N-type material; or
said substrate of said ROM core is a N-type material, and said implants of said ROM core are a P-type material; or
said substrate of said ROM core is at least one well of N-type material, and said implants of said ROM core are a P-type material.

10. A method of forming an array of transistors comprising the steps of:
providing a semi-conductor device having a substrate with a plurality of implants arranged in columns, an insulative layer over the substrate and the implants, and a plurality of rows of gate material within the insulative layer and positioned over the implants so as to form a transistor at each row and column position in an array, each transistor sharing an implant with each adjacent transistor in the same column; and
forming a contact window in the insulative material covering each implant for each transistor;
forming metal layer paths on the insulative material, each of the metal layer paths passing through one of the contact windows and electrically connecting to the implant therebelow; and
forming metal layer jumpers, each of the metal layer jumpers electrically connecting the metal layer paths which are electrically connected to the implants for a select transistor.

11. The method as in claim 10, wherein said step of providing a semi-conductor device having a substrate with a plurality of implants includes either providing said semi-conductor device with the substrate being a P-type material, and the plurality of implants formed therein being a N-type material; or
providing said semi-conductor device with the substrate being at least one well of a P-type material, and the plurality of implants formed therein being a N-type material; or
providing said semi-conductor device with the substrate being a N-type material, and the plurality of implants formed therein being a N-type material; or
providing said semi-conductor device with the substrate being at least one well of a N-type material, and the plurality of implants formed therein being a P-type material.

12. A method of forming a ROM core, comprising the steps of:
providing a semi-conductor device having a substrate with a plurality of columns of implants, an insulative layer over the substrate and the implants, and a plurality of rows of gate material within the insulative layer and positioned over the implants so as to form a transistor row at each position in an array, each transistor sharing an implant with each adjacent transistor in the same column;
forming a contact window in the insulative material covering each implant for each transistor;
forming a plurality of metal layer paths on the insulative material, each of the metal layer paths passing through one of the contact windows and electrically connecting with the implants therebelow;
forming metal layer jumpers, each of the metal layer jumpers electrically connecting the metal layer paths which are electrically connected to the implants for a select transistor.

13. The method as in claim 12, wherein said step of providing a semi-conductor device having a substrate with a plurality of columns of implants includes either providing said semi-conductor device with the substrate being a P-type material, and the implants formed therein being a N-type material; or
providing said semi-conductor device with the substrate being at least one well of a P-type material, and the implants formed therein being a N-type material; or
providing said semi-conductor device with the substrate being a N-type material, and the implants formed therein being a N-type material; or
providing said semi-conductor device with the substrate being at least one well of a N-type material, and the implants formed therein being a P-type material.
